Europäisches Patentamt

European Patent Office

Office européen des brevets

(11) Publication number: **0 295 800 B1**

## EUROPEAN PATENT SPECIFICATION

(45) Date of publication of patent specification: **01.07.92**  (51) Int. Cl.⁵: **H02H 3/33**

(21) Application number: **88304767.2**

(22) Date of filing: **26.05.88**

(54) **Circuit testing.**

(30) Priority: **27.05.87 GB 8712461**

(43) Date of publication of application:
**21.12.88 Bulletin 88/51**

(45) Publication of the grant of the patent:
**01.07.92 Bulletin 92/27**

(84) Designated Contracting States:
**DE FR GB IT**

(56) References cited:
FR-A- 2 530 864      GB-A- 2 047 994
GB-A- 2 181 599      US-A- 3 794 884
US-A- 4 012 668      US-A- 4 056 837

(73) Proprietor: **ROBIN ELECTRONICS LIMITED
Hirst Hall GEC Centre East Lane
Wembley Middlesex HA9 7YA(GB)**

(72) Inventor: **Harris, David Robert
17 St. Leonards Avenue
Kenton Middlesex HA3 8EJ(GB)**
Inventor: **Litherland, Martin Bernard
152 Southcote Lane
Reading Berkshire RG1 6BB(GB)**
Inventor: **Flowerday, Andrew Leslie
46 Brook Street West
Reading Berkshire RG1 6BB(GB)**

(74) Representative: **BATCHELLOR, KIRK & CO.
2 Pear Tree Court Farringdon Road
London EC1R 0DS(GB)**

Rank Xerox (UK) Business Services

## Description

The present invention relates to a method and apparatus for carrying out or facilitating testing of electrical circuits, and in particular, though not exclusively to a method and apparatus for testing the impedance in an alternating current (AC) mains supply between the phase and earth lines.

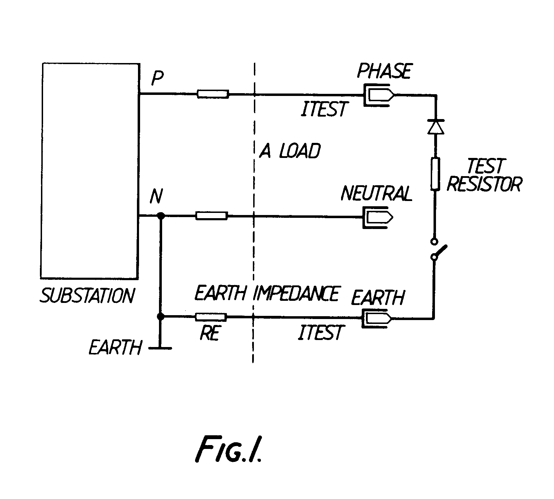

The impedance of the phase-earth loop in an AC power supply is very important and all new installations or modifications have to be tested to verify that impedance. Test methods and equipment have been developed to establish the impedance of the phase-earth loop, and a simplified example of one of these is shown in Figure 1. In general terms, the test is made by measuring the voltage between the phase and earth lines with and without a test resistor of known value in circuit. It is then possible to determine the phase-earth impedance. During the test with the resistor in circuit a current, Itest, flows in the phase-earth loop. To obtain a reasonable impedance measurement resolution the value of the test resistor must be low and the value of the test current that flows to earth is correspondingly high. In unprotected circuits these known methods and equipment operate satisfactorily. However, with circuits including circuit breakers for protecting users or connected equipment, there can be considerable problems because the test current can cause a circuit breaker to trip. This can invalidate the test, but worse, it will interrupt the power supply to equipment on the protected circuit. If, for example a computer system is connected to that circuit the cost in terms of data loss and even damage to equipment can be very high.

One type of circuit breaker used for protection on AC mains supplies is the residual current circuit breaker (RCCB), which detects any imbalance in the current flow in the phase-neutral loop, usually this will be caused by current passing from the phase line to earth. To accomplish this detection the RCCB has a magnetically coupled sensing circuit which is sensitive to the current balance in the phase/neutral loop. When the test described above is carried out, the test current flows only in the phase-earth loop, so that an RCCB would detect a current imbalance between the phase and neutral lines and be triggered. To avoid this it is necessary to remove any RCCB'S from the circuit to be tested. This is clearly undesirable, time consuming and inconvenient.

The present invention seeks to provide a method for temporarily disabling an RCCB protecting an AC circuit, so that tests can be made on that circuit.

In another aspect the present invention seeks to provide apparatus for testing an AC circuit, including an RCCB.

Accordingly the present invention provides a method of temporarily disabling an RCCB having a magnetically coupled sensing circuit, in an AC circuit, the method comprising:

a) connecting a direct current power source to the circuit being protected by the RCCB, and

b) injecting saturating direct current from the direct current power source into the circuit protected by the RCCB, in order to magnetically saturate the sensing circuit of the RCCB, thereby desensitising the RCCB, so that the RCCB is rendered temporarily inoperative thus allowing a test to be made on the circuit.

By injecting a saturating DC current into the protected circuit, the magnetically coupled sensing circuit of the RCCB which would normally detect any imbalance current, is magnetised sufficiently so that any imbalance current flowing is not effective on the magnetically susceptible sensing circuit and the RCCB does not respond. Thus, a circuit test, for example the phase-earth loop test described above may be carried out without the RCCB being triggered.

Preferably the amount of direct current (DC) injected is progressively increased from a low level towards the saturating level. An RCCB might be triggered by a sudden, large DC current, but by increasing the direct current gradually from a low level that can be avoided. Preferably the direct current is reduced progressively to a lower level after having been at the saturating level.

In another aspect the invention provides an apparatus for temporarily disabling an RCCB having a magnetically coupled sensing circuit, protecting an AC supply: comprising a DC current source means for connection to the protected supply for injecting a saturating DC current into the supply for increasing the magnetisation of the magnetic circuit towards saturation thereby disabling the sensing circuit of the RCCB, so that a part of the supply protected by the RCCB may be tested without the RCCB being triggered.

It is preferable that the apparatus includes a controller means for controlling the output of the DC current source means, and the controller means can increase the current injected into the protected circuit, progressively towards saturation current. By progressively increasing the magnetisation the rate of change of magnetic flux in the magnetically coupled sensing circuit can be controlled to a level which is insufficient to cause the RCCB to respond. Similarly, it is preferred that the controller reduces the output of the DC current source means progressively to reduce the magnetisation of the magnetically coupled sensing circuit of the RCCB.

In a further aspect the invention provides apparatus for testing the Phase-Earth impedance of a Phase-Neutral-Earth AC supply with Phase-Neutral lines protected by an RCCB, comprising:

a test circuit means for selectively testing between first and second output terminals to determine the impedance of a circuit connected to those terminals;

a DC current source means for providing a controllable current output between second and third output terminals;

a controller means for controlling the DC current source means to provide a time varying current output, and also for controlling the timing of operation of the test circuit means;

whereby, with the first, second and third terminals connected to the Phase, Earth and Neutral lines of the protected supply the controller can progressively increase the current output of the DC current source means to inject into the Neutral-Earth loop of the AC supply direct current to magnetise the magnetically coupled sensing circuit of the RCCB towards saturation, and thereafter, the controller can operate the test circuit means to test the impedance of the Phase-Earth loop of the AC supply without the RCCB being triggered.

A preferred embodiment of the invention will now be described with reference to the accompanying drawings, wherein:

Figure 1 is a schematic diagram illustrating the principle of a known phase-earth loop testing;

Figure 2 is a schematic block diagram of a circuit test apparatus of the preferred embodiment of the invention;

Figure 3 is a graphical representation of the variation with time of direct current supplied to the circuit to be tested, to magnetise a sensing circuit of an RCCB.

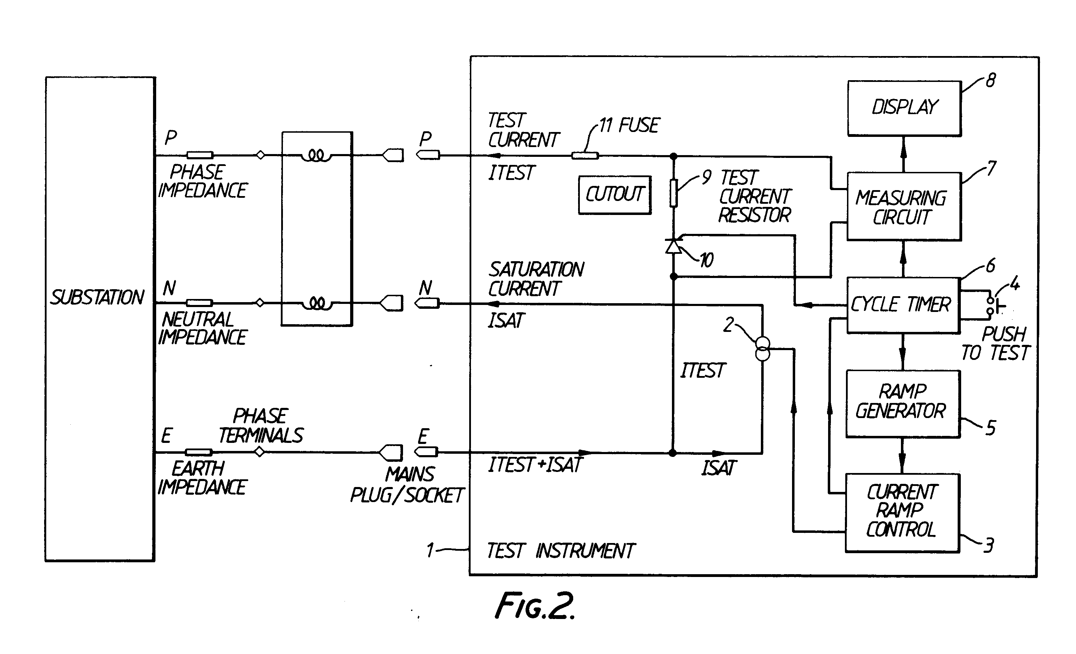

Referring to Figure 2, a phase-earth loop test instrument 1 is shown with connections to an AC mains supply with the phase-neutral lines of the AC mains supply being protected by an RCCB. The test apparatus 1 includes a DC current source 2 connected to output terminals N and E, and which is controlled by a current ramp controller 3. The current ramp controller 3 is for controlling the current source, so that the source 2 provides, in general terms a ramped up and then down supply of direct current. The current ramp controller 3 is connected to receive a reference output from ramp generator 5, and to provide a signal level output to a cycle timer 6. Cycle timer 6 is for controlling the timing of the operation of the test apparatus and is connected to provide an initiation control signal to ramp generator 5. The cycle timer 6 is in turn controlled by push-to-test button 4.

The test apparatus also includes a test resistor 9, which in series with thyristor 10 and protective fuse 11 is connected between the output terminals P and E. The thyristor 10 has its control gate connected to cycle timer 6 while a measuring circuit 7 is connected to measure the voltage across the P and E terminals to determine the impedance of the circuit connected to the terminals P and E. Cycle timer 6 is connected to measuring circuit 7 to control operation of that circuit. A display 8 is connected to measuring circuit 7 for displaying the determined impedance. A thermal cut-out 12 is provided to respond to overheating of test resistor 9, to disable the test apparatus.

The impedance determining circuitry of test resistor 9, measuring circuit 7, and display 8 is in principle as already described in known testers. The control of operation of that test circuitry by cycle timer 6 in conjunction with thyristor 10 represents a significant part of the embodiment of the present invention.

More significant still is the function and role of DC power source 2 which can best be described in operational terms, and in the present exemplary embodiment the arrangement shown in Figure 2 will be referred to further. As shown in that Figure, a notional sub-station provides Phase (P), Neutral (N) and Earth (E) lines. Although not shown it will be understood that somewhere in the AC supply system, probably at the sub-station there will be a connection between Neutral and Earth lines. Between the sub-station and the AC mains outlet, an RCCB is connected to detect any current imbalance between the Phase and Neutral lines, as for example would be caused if there was significant leakage from the Phase to Earth. As already discussed above, an attempt to test the Phase-Earth loop with a conventional tester which puts a low value resistance between the Phase and Earth outlet terminals, would result in the RCCB sensing a current imbalance in the Phase-Neutral loop and consequently being triggered.

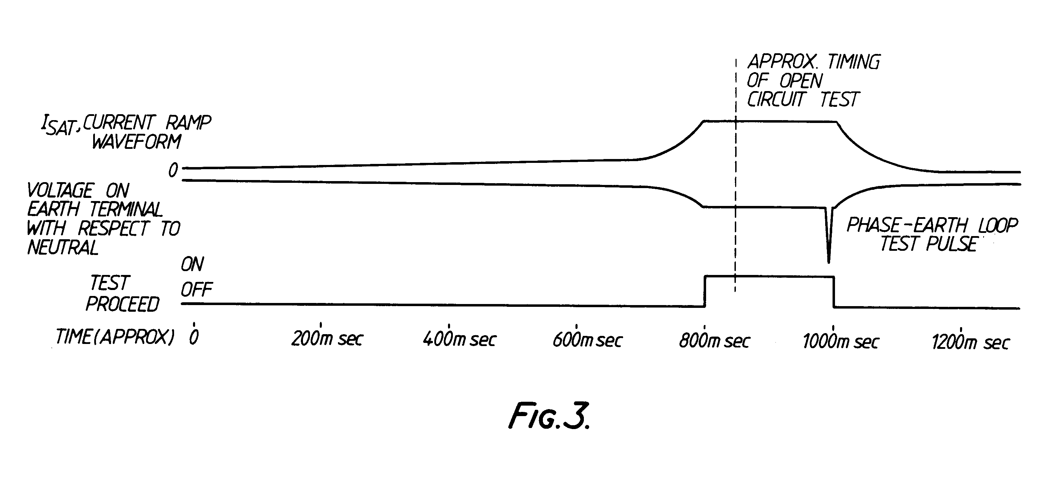

The test apparatus of the present embodiment is connected to the protected AC supply with the output terminals, P, N and E connected to the Phase, Neutral, and Earth lines respectively. A test sequence is initiated by depression of test button 4. The test cycle will be described with additional reference to Figure 3.

Initially the current source 2 is off and the test resistor 9 out of circuit by virtue of the thyristor 10 being off. Upon depression of push button 4 operation of cycle timer 6 commences. Cycle timer 6 provides an initial control signal to ramp generator 5, which then provides the reference ramp signal to current ramp control 3. The current ramp control 3 turns on and gradually increases the current output of DC current source 2 so that DC current, $I_{SAT}$ is injected into the Neutral-Earth loop. The RCCB will not respond to the gradually increasing DC current provided the rate of increase in current is insufficient to cause a sufficiently rapid change of flux in the magnetically coupled sensing circuit of the RCCB to trigger the RCCB. The sensing circuit of the RCCB is at its most sensitive at the start of the current injection procedure, and so the current is injected initially at a low rate (see Figure 3) but as the sensitivity of the sensing circuit is reduced the current can be and is, injected more quickly. It is undesirable to keep the RCCB desensitised, and therefore inoperative, for longer than necessary, so this current ramping procedure is preferable to help keep that inactive period to a minimum.

When the DC current reaches a determined value the magnetisation of the magnetically coupled sensing circuit of the RCCB will approach saturation, so that imbalance current fluctuations in the Phase-Neutral loop will not be sensed, provided that these fluctuations are of the same polarity as the DC saturating current, or if of the opposite provided they are insufficient to cause the magnetisation to be removed. The current ramp control 3 provides a "Test Proceed" signal to cycle timer 6 indicating that ramping up of the direct current has been completed.

On receipt of the "Test Proceed" signal, the cycle timer 6 initiates the testing of the Phase-Earth loop by the measuring circuit 7 which first determines the open-circuit voltage. Then, the thyristor 10 is triggered to bring the test resistor 9 into circuit. The test resistor is brought into circuit on half-cycles of the AC voltage which are in the same phase as the applied DC current so that the effect would be to tend to increase the magnetisation of the magnetic circuit of the RCCB, thereby avoiding the possibility of accidentally removing that saturation. While the test resistor is in circuit the measuring circuit 7 establishes the voltage drop across the resistor, and the Phase-Earth impedance is determined from that measurement and the earlier open circuit measurement. The resulting determined impedance is displayed on display 8. Meanwhile once the test measurements have been completed, the cycle timer 6 provides a further control signal to ramp generator 5 which provides a decreasing ramp reference signal to the current ramp control 3 which consequently decreases the output of DC current source 2 to zero, gradually; again so that the rate of change of flux in the magnetically coupled sensing circuit of the RCCB is insufficient to trigger the RCCB. Thus the current is initially reduced relatively quickly, but the rate of reduction is reduced as time goes on to keep the rate of change of flux below that which would trigger the sensing circuit. Once the saturation current has been removed the RCCB will again be responsive to current imbalance in the Phase-Neutral loop.

The DC current source 2 should be driven from a voltage sufficient to overcome any normal AC potential existing between Neutral and Earth, in addition to driving the required current through the Neutral Earth impedance. Conveniently the source may be driven from a switched mode supply running from the Phase-Neutral circuit.

**Claims**

1. A method of temporarily disabling an RCCB having a magnetically coupled sensing circuit, in an AC circuit, the method comprising:
   a) connecting a direct current power source to the circuit being protected by the RCCB, and
   b) injecting saturating direct current from the direct current power source into the circuit protected by the RCCB, in order to magnetically saturate the sensing circuit of the RCCB, thereby desensitising the RCCB, so that the RCCB is rendered temporarily inoperative thus allowing a test to be made on the circuit.

2. A method as claimed in claim 1 wherein, the amount of direct current (DC) injected is progressively increased from a low level towards the saturating level.

3. A method as claimed in claim 1 or 2, wherein the direct current is reduced progressively to a lower level after having been at the saturating level.

4. An apparatus for temporarily disabling an RCCB having a magnetically coupled sensing circuit, protecting an AC supply: comprising a DC current source means (2, 3, 5 and 6) for connection to the protected supply for injecting DC current into the supply for increasing the magnetisation of the magnetic circuit towards saturation thereby disabling the sensing circuit of the RCCB, so that a part of the supply protected by the RCCB may be tested without the RCCB being triggered.

5. An apparatus as claimed in claim 4, wherein the current source means provides current to cause saturation of the magnetically coupled sensing circuit of the RCCB.

6. An apparatus as claimed in claim 4 or 5, wherein there is a controller means (3, 5, 6) for controlling the output of the DC current source means (2), and the controller means can increase the current injected into the protected circuit, progressively towards saturation current.

7. An apparatus as claimed in claim 6, wherein the controller (3, 5, 6) reduces the output of the DC current source means progressively to reduce the magnetisation of the magnetically coupled sensing circuit of the RCCB.

8. An apparatus for testing the Phase-Earth impedance of a Phase-Neutral-Earth AC supply with Phase-Neutral lines protected by an RCCB, including apparatus according to claim 6 for temporarily disabling the RCCB, and comprising:

a test circuit means (6, 7, 8, 9, 10) for selectively testing between first and second output terminals to determine the impedance of a circuit connected to those terminals,

the DC current source means being connected between said second and third output terminals,

and the controller means being arranged to control the DC current source means to provide a time varying current output, and also for controlling the timing of operation of the test circuit means,

whereby, with the first, second and third terminals connected to the Phase, Earth and Neutral lines of the protected supply the controller can progressively increase the current output of the DC current source means (2) to inject into the Neutral-Earth loop of the AC supply direct current to magnetise the magnetically coupled sensing circuit of the RCCB towards saturation, and thereafter, the controller (5, 6) can operate the test circuit means to test the impedance of the Phase-Earth loop of the AC supply without the RCCB being triggered.

**Revendications**

1. Procédé pour désactiver temporairement un interrupteur de courant résiduel (ICR) comportant un circuit senseur à couplage magnétique, appartenant à un circuit de courant alternatif, lequel procédé consiste :

a) à connecter une source de courant continu au circuit protégé par le ICR;

b) à injecter un courant continu saturant, provenant de la source de courant continu, dans le circuit protégé par le ICR, désensibilisant ainsi le ICR, de sorte qu'il est rendu temporairement inopérant, ce qui permet d'effectuer un essai du circuit.

2. Procédé selon la revendication 1, caractérisé en ce qu'on augmente progressivement la quantité de courant continu injectée à partir d'un niveau relativement bas jusqu'au niveau de saturation.

3. Procédé selon la revendication 1 ou 2, caractérisé en ce qu'on réduit progressivement le courant continu jusqu'à un certain niveau inférieur après que le niveau de saturation avait été atteint.

4. Appareil pour désactiver temporairement un interrupteur de courant résiduel (ICR) possédant un circuit senseur à couplage magnétique, protégeant une alimentation de courant alternatif, qui comprend une source de courant continu (2, 3, 5 et 6) destinée à être connectée à l'alimentation électrique protégée afin d'y injecter du courant continu pour augmenter la magnétisation du circuit magnétique vers la saturation, en désactivant ainsi le circuit senseur du ICR, de sorte qu'une partie de l'alimentation protégée par le ICR peut être contrôlée sans déclencher le ICR.

5. Appareil selon la revendication 4, caractérisé en ce que la source de courant délivre un courant qui provoque la saturation du circuit senseur à couplage magnétique du ICR.

6. Appareil selon la revendication 4 ou 5, caractérisé en ce qu'il comprend un moyen (3, 5, 6) pour contrôler le courant de sortie de la source de courant continu (2), ce moyen pouvant augmenter l'intensité du courant injecté dans le circuit protégé progressivement vers la saturation.

7. Appareil selon la revendication 6, caractérisé en ce que le contrôleur (3, 5, 6) diminue progressivement le courant de sortie de la source de courant continu afin de diminuer la magnétisation du circuit senseur à couplage magnétique du ICR.

8. Appareil pour contrôler ou vérifier l'impédance de la phase neutre mise à la terre d'un circuit d'alimentation à courant alternatif dont les lignes de la phase neutre sont protégées par un interrupteur de courant résiduel ICR, incluant un appareil tel que spécifié dans la revendication 6 pour désactiver temporairement le ICR, et qui comprend :

un circuit de contrôle ou d'essai (6, 7, 8, 9, 10) pour vérifier sélectivement le circuit entre la première et la seconde bornes de sortie afin de déterminer l'impédance du circuit branché entre ces bornes,

la source de courant continu étant branchée entre la seconde et la troisième bornes;

les moyens de contrôle étant arrangés de façon à régler la source de courant continu pour qu'elle fournisse un courant de sortie variable dans le temps, et aussi pour contrôler la chronologie du fonctionnement du circuit d'essai,

ce qui fait que quand la première, la seconde et la troisième bornes sont connectées aux lignes de phase, de terre et neutre du circuit d'alimentation protégé, le contrôleur peut augmenter progressivement le courant de sortie de la source de courant continu (2) pour injecter dans la boucle terre/neutre de l'alimentation alternative du courant continu afin de magnétiser le circuit senseur à couplage magnétique du ICR vers la saturation et, qu'ensuite, le contrôleur (5, 6) peut actionner le circuit d'essai afin de contrôler l'impédance de la boucle phase/terre de l'alimentation alternative sans déclencher le ICR.

## Patentansprüche

1. Verfahren zur zeitweiligen Abschaltung eines ReststromLeistungsschalters (RCCB) mit einer magnetisch gekoppelten Fühlerschaltung in einem Wechselstromkreis, bei dem man
   a) eine Gleichstromquelle an den durch den RCCB geschützten Kreis anschließt und
   b) aus der Gleichstromquelle Sättigungsgleichstrom in den durch den RCCB geschützten Kreis einspeist, um die Fühlerschaltung des RCCB magnetisch zu sättigen und dadurch den RCCB zu unterbrechen, so daß dieser vorübergehend außer Betrieb genommen wird und dadurch eine Prüfung in dem Kreis ermöglicht wird.

2. Verfahren nach Anspruch 1, bei dem die Menge des eingespeisten Gleichstroms (DC) von einem niedrigen Wert gegen den Sättigungswert progressiv gesteigert wird.

3. Verfahren nach Anspruch 1 oder 2, bei dem der Gleichstrom progressiv auf einen niedrigen Wert verringert wird, nachdem er auf dem Sättigungswert gewesen ist.

4. Apparatur zur zeitweiligen Abschaltung eines ein Wechselstromnetz schützenden RCCB mit einer magnetisch gekoppelten Fühlerschaltung, mit einer Gleichstromquelle (2,3,5 und 6) zum Anschluß an das geschützte Stromnetz zwecks Gleichstromeinspeisung in das Versorgungsnetz zur Steigerung der Magnetisierung der magnetischen Schaltkreises zur Sättigung hin, wodurch die Fühlerschaltung des RCCB abgeschaltet wird, so daß ein Teil des durch den RCCB geschützten Netzes ohne Triggerung des RCCB geprüft werden kann.

5. Apparatur nach Anspruch 4, bei der die Stromquelle Strom liefert, um die Sättigung der magnetisch gekoppelten Fühlerschaltung des RCCB zu bewirken.

6. Apparatur nach Anspruch 4 oder 5, bei der ein Steuerteil (3,5,6) zur Steuerung der Ausgangsleistung der Gleichstromquelle (2) vorgesehen ist und das Steuerteil den in den geschützten Kreis eingespeisten Strom progressiv zum Sättigungsstrom hin steigern kann.

7. Apparatur nach Anspruch 6, bei der das Steuerteil (3,5,6) die Ausgangsleistung der Gleichstromquelle progressiv verringert, um die Magnetisierung der magnetisch gekoppelten Fühlerschaltung des RCCB zu reduzieren.

8. Apparatur zur Prüfung der Phase-Erde-Impedanz eines Phase-Neutral-Erde-Wechselstromnetzes mit durch einen RCCB geschützten Phase-Neutral-Leitungen unter Einschluß einer Apparatur nach Anspruch 6 zur zeitweiligen Abschaltung des RCCB, bei der
   eine Prüfschaltung (6,7,8,9,10) zur selektiven Prüfung zwischen der ersten und zweiten Ausgangsklemme vorgesehen ist, um die Impedanz eines an diese Klemmen angeschlossenen Kreises zu bestimmen,
   die Gleichstromquelle zwischen der genannten zweiten Ausgangsklemme und der dritten Ausgangsklemme angeschlossen ist und
   das Steuerteil vorgesehen ist, um die Gleichstromquelle so zu steuern, daß sie einen sich mit der Zeit ändernden Ausgangsstrom liefert, und auch um die Zeitsteuerung des Betriebs der Prüfschaltung zu regeln,
   wodurch bei an die Phasen-, Erd- und Neutralleitungen des geschützten Stromnetzes angeschlossener erster, zweiter und dritter Klemme das Steuerteil den Ausgangsstrom der Gleichstromquelle (2) progressiv steigern kann, um zur Magnetisierung der magnetisch gekoppelten Fühlerschaltung des RCCB zur Sättigung hin Gleichstrom in die Neutral-Erde-Schleife der Wechselstromquelle einzuspeisen, worauf das Steuerteil (5,6) den Prüfkreis betreiben kann, um ohne Triggerung des RCCB die Impedanz der Phase-Erde-Schleife des Wechselstromnetzes zu prüfen.

**FIG.1.**

FIG.2.

EP 0 295 800 B1

$I_{SAT}$, CURRENT RAMP
WAVEFORM

0

VOLTAGE ON
EARTH TERMINAL
WITH RESPECT TO
NEUTRAL

APPROX. TIMING
OF OPEN
CIRCUIT TEST

PHASE-EARTH LOOP
TEST PULSE

TEST
PROCEED

ON
OFF

TIME (APPROX) 0    200m sec    400m sec    600m sec    800m sec    1000m sec    1200m sec

FIG.3.

EP 0 295 800 B1